# EUROPEAN PATENT SPECIFICATION

(11) **EP 0 829 016 B1**
(45) Date of publication and mention of the grant of the patent: **03.09.2003**
(21) Application number: 95920123.7
(22) Date of filing: 02.06.1995
(51) Int. Cl.: G01R 33/035

(54) **SQUID MAGNETOMETER**
SQUID MAGNETOMETER
MAGNETOMETRE A SQUID

(43) Date of publication of application: 18.03.1998
(73) Proprietor: VALTION TEKNILLINEN TUTKIMUSKESKUS, 02150 Espoo 15 (FI)
(72) Inventor: SEPPÄ, Heikki, FIN-02150 Espoo (FI)
(74) Representative: Simmelvuo, Markku Kalevi
(86) International application number: FI9500316
(87) International publication number: WO96038737

(56) References cited:
- EP-A- 0 619 497
- US-A- 5 387 864
- IEEE TRANSACTIONS ON MAGNETICS, Volume 27, No. 2, March 1991, R. CANTOR et al., "Design and Optimization of DC Squids Fabricated Using a Simplified Four-Level Process", pages 2927-2931.
- PROCEEDINGS OF THE TENTH INTERNATIONAL CRYOGENIC ENGINEERING CONFERENCE, 1984, Butterworth, (Helsinki), ILMONIEMI R. et al., pages 457-460.

## Description

The present invention relates to a SQUID magnetometer and to a method for suppressing LC and microwave resonances in SQUID structures.

The SQUID detector or SQUID (Superconducting QUantum Interference Device) is used for the measurement of weak magnetic fields. The SQUID has an output impedance of only about 1 - 5 W. Its operating temperature is typically 4.2 K, to which temperature it is cooled by suitable means. The operating temperature depends on the superconducting material used in the SQUID, therefore the operating temperature is as low as required for the operation of the superconductor. The noise at the output is very low; it is hardly higher than the thermal noise in the resistors used for the damping of the Josephson junctions. SQUID detectors are often used to measure low-frequency signals in the range of 0.1 Hz - 10 kHz.

The problem with the type of detectors described above is that it is difficult to amplify the output signal without increasing the noise. The reason for this is that the range of voltage variation in the output signal is relatively narrow, about 10 µV - 100 µV peak to peak. Moreover, the noise at the output of the SQUID roughly corresponds to the thermal noise of the resistors used for the damping of the Josephson junctions. If the noise temperature of an amplifier connected after a SQUID at 4.2 K temperature is below 10 K, the amplifier does not significantly increase the uncertainty of magnetic flux measurement.

No ordinary dc-connected amplifier operating at room temperature has sufficiently low output noise when connected directly to a SQUID. This is due to the low output imepdance of the SQUID and to the fact that it is often used to measure low-frequency signals in the range of 0.1 Hz - 10 kHz. As FET amplifiers have a very low noise temperature in a frequency range of 1 kHz - 100 kHz, flux modulation and a cryogenic transformer are used in connection with a dc SQUID detector to match the low impedance of the SQUID with the FET amplifier. With this arrangement, the uncertainty of the magnetic flux measurement is chiefly determined by the noise of the SQUID. Moreover, it can be proved both theoretically and experimentally that, as the SQUID noise is reduced, the magnetic flux-voltage conversion also increases so that the requirements regarding the signal processing electronics are not heightened.

However, problems ensue when several SQUID detectors are connected together to form multichannel devices. An example of such devices is the multichannel magnetometer. In recent times, these have been produced for the measurement of the weak magnetic fields of the brain and the heart. At present, the aim is to achieve magnetometers with 30 - 100 channels. If such a multichannel magnetometer is realized using SQUID detectors and the flux modulation technique, the costs of the signal processing electronics will be significant because each SQUID and channel requires a cryogenic transformer, preamplifier, modulator etc. The electronics of a multichannel magnetometer like this will be really complex and expensive.

The output signal of the SQUID can also be amplified by connecting the signal back to the SQUID's input via an extra coil and a resistor connected in series with it. The additional circuit thus formed causes positive feedback if the SQUID is current-biased.

Positive feedback amplifies the output signal, but it can also render the system instable. Instability can be controlled by replacing the resistor e.g. with a field- effect transistor, by means of which the resistance value can be easily adjusted.

If the SQUID is voltage-biased, an additional circuit can be used to cancel the noise in the output voltage of an operatinal amplifier. In this case, too, the electronics can be advantageously implemented using a variable resistor for the control of noise cancellation. The methods described above are reasonably simple, but generally they are not quite sufficient to reach the noise level of the SQUID.

Dc SQUID magnetometers are traditionally manufactured from two Josephson junctions with a damping resistor connected across them. If the Josephson junction is not resistively damped, it will have a hysteretic characteristic. Correspondingly, a dc SQUID composed of undamped junctions is hysteretic and cannot be used as a magnetometer. If the damping is insufficient, the dc SQUID will work but its noise may remain high. The thermal noise of the damping resistors limits the resolution of a dc SQUID, which is why the aim is to use a damping level as low as possible, yet so that the system remains stable. In practice, the junctions are often over-damped to ensure that the resonances associated with the dc SQUID connection circuits will not produce instability and increase the noise.

Document IEEE TRANSACTIONS ON MAGNETICS, Vol 27, No. 2, Mar 1991, R. Cantor et al, 'Design and Optimization of DC Squids Fabricated Using Simplified Four-Level Process', pages 2927-2931" concerns the research in which the state of the art in the field SQUID magnetometers has been studied. Particularly, this research work deals with the problems of the parasitic circuits in the SQUID magnetometer. In said document the noise dissipation of the SQUID is not called into question but the different methods for that are studied. Said document does not suggest the noise damping in which the high frequency oscillations and low frequency oscillations are treated in different stages, i.e. in the SQUID itself and in the next stage after the SQUID.

In document EP 619497 is disclosed a SQUID sensor device containing a DC SQUID and electronics for amplifying voltage signals produced using the SQUID. According to the document, it is intended for the SQUID to be operated as a detecting SQUID with an electrical fundamental voltage (voltage bias) and to be part of a series circuit having an output coupling coil, via which a DC readout SQUID is to be driven inductively using the signals of the detecting SQUID, the signals of the DC readout SQUID are to be supplied to the electronics arranged downstream. The object of the invention is to eliminate the drawacks described above or at least to reduce them significantly.

A special object of the invention is to present a SQUID magnetometer which is based on non-damped Josephson junctions and which can be damped so that the whole system becomes stable without separate damping of the junctions. The features defined by claim 1 achieve this object.

According to the invention, the properties of the SQUID can be so adjusted that it will have a higher gain than currently used SQUIDS and, most importantly, the effective flux noise can be reduced. Another essential feature is that implementing the damping as provided by the invention also makes it possible to consider the effect of the biasing and the preamplifier in the planning of the damping. For the dynamics of the SQUID, this means that the preamplifier will be a part of the SQUID detector and vice versa. Moreover, a method which implements the invention ensures that the connection circuits of the SQUID will have no effect on its dynamics. Therefore, the effect of the connection circuits need not be considered in the damping of the SQUID itself. This again means that less damping is required and reduces the noise of the SQUID.

The invention and the SQUID detectors constructed in accordance with it, the un SQUID and the hg SQUID, are based on the inventive idea that they are composed of non-damped Josephson junctions. Thus, the present invention relates to two new types of SQUID (un SQUID and hg SQUID).

In an embodiment of the invention, the traditional damping resistor is replaced with a series connection of a resistor and a capacitor. The value of the resistor R is of the same order of magnitude as in the case where no capacitor is used. Due to the presence of the capacitor, the junction is normally damped by the resistor R at high frequencies - the frequencies at which Josephson oscillations occur (1GHz-100GHz). At low frequencies, the RC circuit provides no resistive damping. No damping is required across the coil between the junctions at low frequencies, either, if the other circuits connected to the SQUID are otherwise well damped. If no additional resistor is connected in parallel with the junctions, the characteristic curves of the SQUID are changed so that the dynamic resistance at the detector output is negative. Consequently, when current-biased, the SQUID is unstable and it cannot be used in the normal way as a magnetometer.

However, if the SQUID is voltage-biased and its current output is read, the SQUID forms a stable device and its output current is proportional tc the flux penetrated by the SQUID ring. By supplying a current into a small resistor (e.g. 0.1 Ohm) and connecting the resistor output through the input of a traditional dc SQUID to the SQUID being examined, an arrangement is achieved where, on the one hand, the SQUID being examined is voltage-biased and, on the other hand, its output current can be detected using a traditional SQUID.

Since in this solution the junctions are not damped at low frequencies but the damping required by the system is produced at low frequencies in the biasing circuit, the effect of thermal noise on the effective flux noise is very small. However, the high-frequency thermal noise is mixed down due to the non-linearity and high-frequency oscillation of the Josephson junctions, so at high temperatures (4.2 K) the noise is probably still determined by the thermal noise and not by the quantum noise.

As the SQUID itself in this arrangement of the invention has no damping at low frequencies, the device is called an unshunted SQUID (un SQUID).

In another embodiment of the invention, an additional resistor is connected transversely in parallel with the SQUID junctions. If the resistance value is of the order of R/2, the response of the SQUID resembles the traditional dc SQUID and the dynamic resistance of its output is always positive. If the resistance value is of the order of 2R, the characteristic curves of the SQUID are more like those of a transistor, i.e. the output current is almost independent of the voltage across the component. The current is only proportional to the flux threading the SQUID ring.

Since the dynamic resistance of the output for a certain bias voltage is almost infinite, the voltage noise of the preamplifier at room temperature does not increase the effective flux noise of the SQUID. In other words, the SQUID has a high gain, and the next amplifier stage does not increase the noise of the detector.

As the characteristic curves are of a parabolic form, the SQUID has to be voltage-biased to avoid oscillation. Operational amplifiers are basically voltage amplifiers, so a voltage bias obtained from them will not necessarily lead to a stable solution when connected to a component having a negative dynamic resistance.

However, if voltage biasing from an operational amplifier is effected by connecting the output of the operational amplifier via a resistance to the output of the SQUID and adjusting the voltage of the SQUID by applying a voltage to a terminal of the operational amplifier, the circuit can be stabilized by adding flux feedback.

In other words, the SQUID together with negative feedback of an operational amplifier forms an unstable device because of the dynamic resistance of the detector, but togecher with negative flux feedback the whole system is stable. Since the dynamic resistance of the detector output is very large (absolute value) with respect to the operational amplifier, its voltage noise does not increase the effective noise of the SQUID. Only the current noise of the operational amplifier has an effect, but typically its significance is smaller than the effect of the internal flux noise of the SQUID.

As the arrangement of the invention leads to a SQUID in which the noise of the operational amplifier (voltage noise) does not increase the noise of the detector, we call such a SQUID a high-gain SQUID (hg SQUID); the detector behaves just as if it had a very high gain.

In both SQUIDs of the invention, the hg SQUID and the un SQUID, the importance of the damping of the flux transmission coils coupled with the SQUID is emphasized. In traditional SQUIDs as well, input circuits with insufficient damping increase the noise of the SQUID. Now, according to the invention, a way has been developed by which all the LC and microwave resonances in the SQUID structures can be sufficiently damped by adding integrated coils, capacitances and resistances to the SQUID structure.

In the following, the invention is desrcribed in detail by referring to the attached drawings, in which
Fig. 1 presents a diagram representing a SQUID detector and output signal processing as known in the art;
Fig. 2 illustrates the dependence of the output voltage of the SQUID on the incident magnetic flux in an arrangement as illustrated by Fig. 1;
Fig. 3 presents a dc SQUID;
Fig. 4 presents an un or hg SQUID in which the resistance has been replaced with a series connection of a resistance and a capacitance;
Fig. 5 presents the circuit of an un or hg SQUID in a general case;
Fig. 6 illustrates the amplification of the output signal of the SQUID;
Fig. 7 presents a hg SQUID;
Fig. 8 presents the voltage-current characteristic of a traditional dc SQUID for different magnetic flux values;
Fig. 9 presents the characteristic curves of a voltage-biased un SQUID and the characteristic curves of a hg SQUID (in broken lines); and
Fig. 10 illustrates the connection of the SQUID to an external antenna via an intermediate transformer.

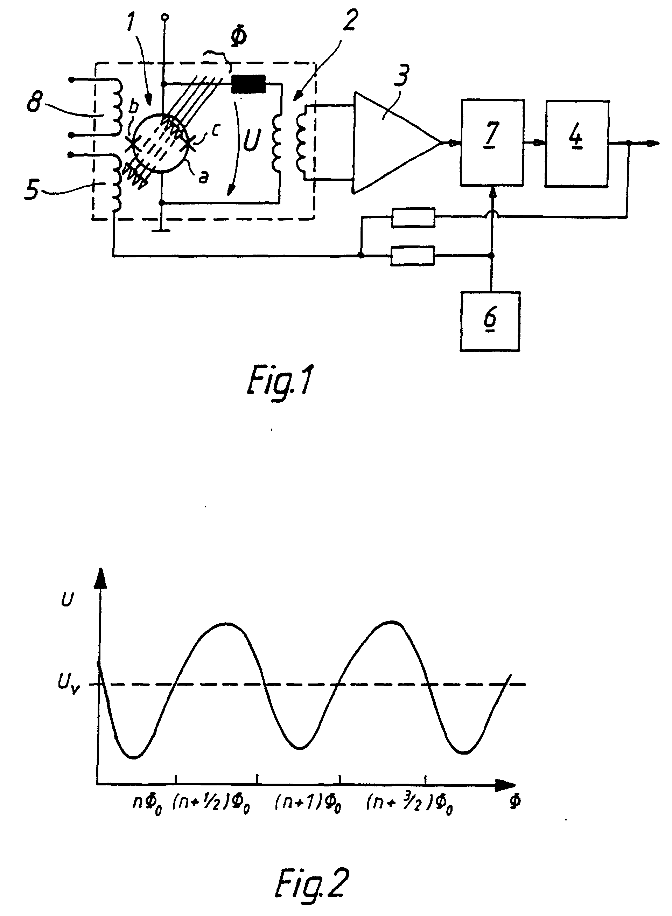

Fig. 1 presents in diagrammatic form a SQUID detector 1 and a conventional output signal processing apparatus. The apparatus comprises a transformer 2, which matches the detector with a FET preamplifier 3. The output of the preamplifier is connected through a demodulator 7 and a regulator 4 to a flux modulation winding 5, to which is also connected a modulator 6. The output signal of the processing apparatus is obtained from the output of the regulator 4. The apparatus also shows a signal winding 8 used to transfer the current or magnetic field to be measured to the ring a of the SQUID 1.

The SQUID 1 consists of a superconducting ring a and one or two Josephson junctions held at a low temperature, e.g. 4.2 K. The transformer 2 and windings 5 and 8 (i.e. the components encircled with a broken line) are also held at the same temperature. In this case, the ring a comprises two Josephson junctions b, c. Such a detector is called a dc SQUID. The detector converts the flux F of the magnetic field threading the superconducting ring into a voltage U. Typically, the SQUID output voltage U as a function of flux F is of a cyclic form as shown in Fig. 2, and it contains a constant portion Uᵥ depending on the critical current of the Josephson junctions. The cycle time is one flux quantum F, = 2.05 10⁻¹⁵ Wb.

The SQUID detector is used together with a modulator 4 or a so-called flux modulator and a cryogenic transformer 2 to match the low impedance of the SQUID with the FET preamplifier. Amplifiers based on the field-effect transistor (FET) have a very low noise temperature in the frequency range of about 1 kHz - 100 kHz.

In the flux modulator 4, the amplitude of a square wave modulation signal is set to a value corresponding to half the cycle time of the response (see Fig. 2); thus there are two operating points for each cycle F, so that the flux modulation will not cause any voltage variation at the output of the SQUID. However, if the external flux causes a shift of the operating point, the square wave appears across the SQUID and is amplified by the amplifier 3 connected after the transformer 2. The regulator 4 restores the flux back to zero by supplying a correcting current into the winding 5 coupled with the SQUID.

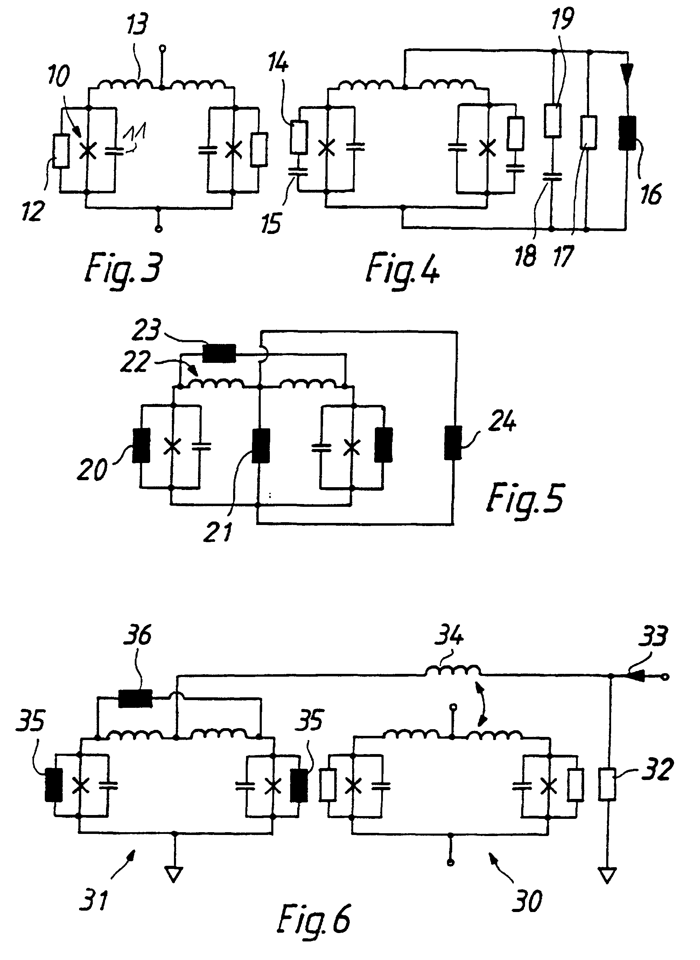

Fig. 3 presents a traditional dc SQUID consisting of a Josephson junction 10, the junction capacitance 11, a resistance 12 connected in parallel with the junction and an inductance 13 connecting the junctions.

Fig. 4 shows an un or hg SQUID in which the resistance 12 has been replaced with a series connection of a resistance 14 and capacitance 15. In the case of an un or hg SQUID, an impedance 16 formed by the biasing circuits and the next amplifier stage appears in parallel with the SQUID. In the case of a hg SQUID, a resistance 17 is connected across the SQUID, which has an influence on the UI characteristics of the SQUID. If the voltage biasing circuit is slow, it is often necessary to include a series connection of a capacitor 18 and a resistance 19 outside the SQUID. The circuit damps the junctions at frequencies that are too high for the operational amplifier but too low for the damping circuits 14 and 15 integrated in the SQUID circuit.

Fig. 5 presents the circuit of an un or hg SQUID in a general case. An essential feature of un and hg SQUIDs is that the damping impedances 20 of the junctions are subject to the rule that at low frequencies the real part of the impedance approaches infinity. In other words, the junctions cannot be damped at low frequencies. At high frequencies, the junctions can alternatively be damped by means of impedance 21. It is possible to connect across the coil 22 a separate damping system 23 which mainly consists of the impedance involved in the connection circuits of the SQUID or of separate damping elements placed at this point. The impedance 24 across the SQUID represents the load impedance formed by the biasing circuit, the next amplifier stage or a separate impedance.

Fig. 6 illustrates the amplification of the output signal of a SQUID based on undamped Josephson junctions. SQUID2 30 measures the output current of un SQUID 31. The current 33 flowing through resistor 32 produces a voltage bias on the un SQUID, applied via the un SQUID input coil 34. The damping of the un SQUID junctions is represented in the figure by impendances 35 and an impedance 36 imposed across the inductances.

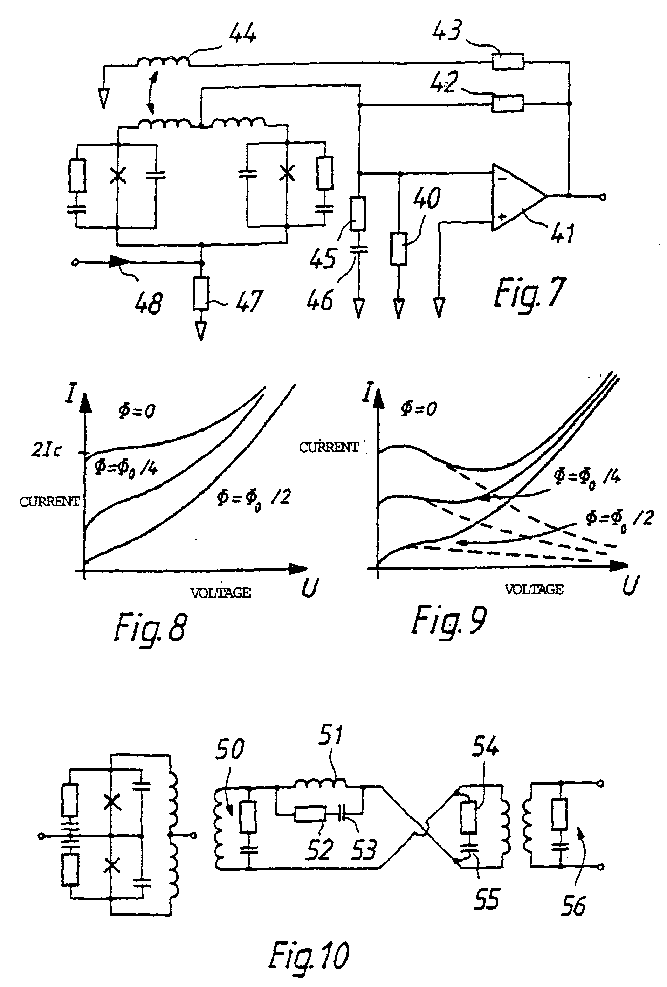

Fig. 7 shows a hg SQUID with a resistor 40 placed across it. The hg SQUID is voltage-biased via operational amplifier 41 and resistor 42. Since the dynamic resistance of the hg SQUID may be negative, the system is only stable if it is provided with negative feedback e.g. by connecting the output of the operational amplifier via a resistor 43 and a coil 44 back to the SQUID. The form of the characteristic is adjusted by means of resistor 40 and the junctions are damped e.g. in the frequency range of 1 MHz - 1 GHz by means of resistor 45 and capacitor 46. The SQUID is voltage-biased by means of resistor 47 and current 48.

Fig. 8 shows the voltage/current characteristics of a traditional dc SQUID for different magnetic flux values. The current that produces a voltage across the SQUID when the flux is zero is 2Ic, where Ic is the critical current of the Josephson junction. In Fig. 9, the solid lines represent the characteristics of a voltage-biased un SQUID. Voltage-biasing means that a low-impedance source is connected across the SQUID and the current flowing through the source is measured. The characteristics of the hg SQUID are depicted with broken lines. The resistance across the hg SQUID has an effect on the form of the characteristic. Unlike the normal dc SQUID, the un SQUID and hg SQUID have characteristics resembling those of a transistor. Because of its high dynamic output resistance, the hg SQUID has a gain higher than that of an ordinary dc SQUID. The un SQUID has a negative output resistance and, due to the reduced low-frequency damping of the junctions, exhibits less noise than a normal dc SQUID or a hg SQUID.

As illustrated by Fig. 10, the SQUID is often connected to an external antenna via an intermediate transformer. The transformer constitutes a transmission line. The microwave signal flowing in the transmission line may be reflected at impedance discontinuities. Often the transmission line is terminated in an RC circuit 50. Especially when an intermediate transformer with an RC circuit is used, sufficient matching is not achieved. This is because at high frequencies the secondary of the intermediate transformer represents a condition almost equal to a short-circuit. By adding e.g. a coil 51 and in parallel with it a series connection of a resistance 52 and a capacitor 53, the transmission line can be so matched that no reflections arise. In addition, the figure-8-shaped intermediate transformer can be provided a series connection of a resistance 54 and a capacitor 55 and the transformer following the intermediate transformer must be provided with an RC circuit 56.

Achieving a low noise level requires the use of all the components described above, but the arrangement described here concerns a series circuit which is placed in the antenna structure of the SQUID or in the intermediate transformer and in which the inductance is superconducting and a lossy circuit, e.g. a series connection of a resistor and capacitor, is placed across it. The lossy circuit connected across the coil may also be a more complex one than an RC circuit. The essential point is, however, that at low frequencies the circuit does not produce a noise current in the intermediate transformer or in the antenna inductor, which would increase the noise of the SQUID.

## Claims

1. SQUID magnetometer (1) comprising two Josephson junctions (10), **characterized in that**, at high frequencies - at frequencies at which Josephson oscillations occur - the Josephson junctions are damped by including damping impedances (20) having a resistive and a reactive component across the Josephson junctions in the SQUID magnetometer and the damping needed by the SQUID at low frequencies is produced by a load impedance (24) across said SQUID.

2. SQUID magnetometer as defined in claim 1, **characterized** in that the damping impedance is an RC circuit consisting of a series connection of a resistor R (14) and capacitor C (75), connected across the Josephson junctions.

3. SQUID magnetometer as defined in claim 1, **characterized in that** an additional resistor (21) is connected in parallel with the junctions.

4. SQUID magnetometer as defined in claim 3, **characterized in that** the additional resistor (21) is of the order of magnitude of R/2, rendering the response of the SQUID similar to that of the traditional dc SQUID and the dynamic resistance of its output positive.

5. SQUID magnetometer as defined in claim 3, **characterized in that** the additional resistor (21) is of the order of magnitude of 2R, causing the characteristic curves of the SQUID to resemble parabolas.

6. SQUID magnetometer as defined in claim 1, **characterized** in that an additional damping impedance (23) is connected across an inductance connecting the Josephson junctions.

7. SQUID magnetometer as defined in claim 1, **characterized in that** the load impedance (24) is formed by a biasing circuit.

8. SQUID magnetometer as defined in claim 1, **characterized in that** the load impedance (24) is formed by an amplifier stage following the SQUID.

9. SQUID magnetometer as defined in claim 1, **characterised in that** the load impedance (24) is formed by a separate impedance.

## Patentansprüche

1. SQUID-Magnetometer (1), welches zwei Josephson-Übergänge (10) aufweist,
**dadurch gekennzeichnet,**
**daß** bei hohen Frequenzen - bei Frequenzen, bei denen Josephson-Oszillationen auftreten - die Josephson-Übergänge gedämpft werden, indem Dämpfungsimpedanzen (20), welche eine Widerstandskomponente und eine Blindkomponente haben, parallel zu den Josephson-Übergängen in dem SQUID-Magnetometer eingesetzt sind,
und **daß** die von dem SQUID benötigte Dämpfung bei niedrigen Frequenzen von einer Lastimpedanz (24) parallel zu dem SQUID erzeugt wird.

2. SQUID-Magentometer nach Anspruch 1,
**dadurch gekennzeichnet,**
**daß** die Dämpfungsimpedanz ein RC-Kreis ist, der aus einer Serienschaltung aus einem Widerstand R (14) und einem Kondensator C (15) besteht, die parallel zu den Josephson-Übergängen geschaltet ist.

3. SQUID-Magentometer nach Anspruch 1,
**dadurch gekennzeichnet,**
**daß** ein zusätzlicher Widerstand (21) parallel zu den Josephson-Übergängen geschaltet ist.

4. SQUIO-Magentometer nach Anspruch 3,
**dadurch gekennzeichnet,**
**daß** der zusätzliche Widerstand (21) von der Größenordnung R/2 ist und somit das Ansprechverhalten des SQUID ähnlich dem eines herkömmlichen Gleichstrom-SQUIDs und den dynamischen Widerstand seines Ausgangs positiv macht.

5. SQUID-Magentometer nach Anspruch 3,
**dadurch gekennzeichnet,**
**daß** der zusätzliche Widerstand (21) von der Größenordnung 2R ist und somit bewirkt, daß die Kennlinien des SQUIDs Parabeln ähneln.

6. SQUID-Magentometer nach Anspruch 1,
**dadurch gekennzeichnet,**
**daß** eine zusätzliche Dämpfungsimpedanz (23) parallel zu einer Induktivität geschaltet ist, welche die Josephson-Übergänge verbindet.

7. SQUID-Magentometer nach Anspruch 1,
**dadurch gekennzeichnet,**
**daß** die Lastimpedanz (24) von einer Vorspannungsschaltung gebildet ist.

8. SQUID-Magentometer nach Anspruch 1,
**dadurch gekennzeichnet,**
**daß** die Lastimpedanz (24) von einer dem SQUID nachgeschalteten Verstärkerstufe gebildet ist.

9. SQUID-Magentometer nach Anspruch 1,
**dadurch gekennzeichnet,**
**daß** die Lastimpedanz (24) von einer separaten Impedanz gebildet ist.

## Revendications

1. Magnétomètre d'interféromètre quantique supraconducteur (1), comprenant deux jonctions de Josephson (10), **caractérisé en ce que**, aux hautes fréquences, à des fréquences auxquelles des oscillations de Josephson surviennent, les jonctions de Josephson sont amorties en incluant des impédances d'amortissement (20) possédant une composante de résistance et une composante réactive aux bornes des jonctions de Josephson dans le magnétomètre d'interféromètre quantique supraconducteur et l'amortissement requis par l'interféromètre quantique supraconducteur aux basses fréquences est produit par une impédance de charge (24) aux bornes dudit interféromètre quantique supraconducteur.

2. Magnétomètre d'interféromètre quantique supraconducteur selon la revendication 1, **caractérisé en ce que** l'impédance d'amortissement est un circuit RC constitué d'une connexion en série d'une résistance R (14) et d'un condensateur C (15) connectée aux bornes des jonctions de Josephson.

3. Magnétomètre d'interféromètre quantique supraconducteur selon la revendication 1, **caractérisé en ce qu'**une résistance additionnelle (21) est connectée en parallèle avec les jonctions de Josephson.

4. Magnétomètre d'interféromètre quantique supraconducteur selon la revendication 3, **caractérisé en ce que** la résistance additionnelle (21) est d'une valeur de l'ordre de R/2, rendant la réponse de l'interféromètre quantique supraconducteur similaire à celle de l'interféromètre quantique supraconducteur D.C. usuel et la résistance dynamique de sa sortie positive.

5. Magnétomètre d'interféromètre quantique supraconducteur selon la revendication 3, **caractérisé en ce que** la résistance additionnelle (21) est d'une valeur de l'ordre de 2R, rapprochant les courbes caractéristiques de l'interféromètre quantique supraconducteur de paraboles.

6. Magnétomètre d'interféromètre quantique supraconducteur selon la revendication 1, **caractérisé en ce qu'**une impédance additionnelle d'amortissement (23) est connectée aux bornes d'une bobine d'induction connectant les jonctions de Josephson.

7. Magnétomètre d'interféromètre quantique supraconducteur selon la revendication 1, **caractérisé en ce que** l'impédance de charge (24) est formée d'un circuit de polarisation.

8. Magnétomètre d'interféromètre quantique supraconducteur selon la revendication 1, **caractérisé en ce que** l'impédance de charge (24) est formée d'un étage d'amplificateur suivant l'interféromètre quantique supraconducteur.

9. Magnétomètre d'interféromètre quantique supraconducteur selon la revendication 1, **caractérisé en ce que** l'impédance de charge (24) est formée d'une impédance séparée.
